# EUROPEAN PATENT APPLICATION

(11) **EP 1 791 144 A2**
(43) Date of publication of application: **30.05.2007**
(21) Application number: 06121992.9
(22) Date of filing: 09.10.2006
(51) Int. Cl.: H01G 9/20

(54) **Composition for semiconductor electrode sintered at low temperature and dye-sensitized solar cell comprising the composition**

(30) Priority: 24.11.2005 KR 20050112959
(71) Applicant: Electronics and Telecommunications Research Institute, Daejeon-city (KR)
(72) Inventor: Park, Nam Gyu, Daejeon-city (KR); Kim, Kwang Man, Daejeon-city (KR); Ryu, Kwang Sun, Daejeon-city (KR); Kang, Man Gu, Daejeon-city (KR); Chang, Soon Ho, Daejeon-city (KR)
(74) Representative: Betten & Resch

(57) **Abstract**

Provided are a composition for a semiconductor electrode that can be sintered at a low temperature, a manufacturing method thereof, and a dye-sensitized solar cell using the composition. The composition for the semiconductor electrode comprises a colloid solution containing a nanocrystalline oxide material and an aqueous base solution. Even though the composition does not include binders, the composition can be sintered at a low temperature. By coating the composition on a conductive substrate and treating the substrate with a solution of TiCl₄, the sintering between the nanoparticles can be reinforced. The dye-sensitized solar cell manufactured using the composition for the semiconductor electrode can have excellent photoelectric conversion efficiency.

## Description

### CROSS-REFERENCE TO RELATED PATENT APPLICATION

This application claims the benefit of Korean Patent Application No. 10-2005-0112959, filed on November 24, 2005, in the Korean Intellectual Property Office, the disclosure of which is incorporated herein in its entirety by reference.

### BACKGROUND OF THE INVENTION

### 1. Field of the Invention

The present invention relates to a dye-sensitized solar cell, and more particularly, to a dye-sensitized solar cell including a semiconductor electrode containing titanium dioxide nanoparticles.

### 2. Description of the Related Art

Dye-sensitized solar cells are photoelectrochemical solar cells that were invented by Michael Gratzel et al. in 1991. Since dye-sensitized solar cells are less expensive than other solar cells and have an energy conversion efficiency of about 11 %, the dye-sensitized solar cells are expected to be a next generation solar cell that will replace typical silicon solar cells. In general, a dye-sensitized solar cell includes a transparent conductive electrode coated with a nanocrystalline oxide material onto which dye molecules are adsorbed, an opposite electrode coated with metal nanoparticles such as platinum, or carbon, and an iodine based electrolyte for oxidation and reduction reactions.

In a typical method of manufacturing a dye-sensitized solar cell using a transparent conductive glass substrate, a nanocrystalline titanium dioxide (TiO₂) film is coated on a glass substrate and is subjected to a thermal process at a high temperature of 450°C or higher to obtain a TiO₂ based electrode. In detail, to obtain a highly viscous coating solution, a colloid solution including TiO₂ nanoparticles is mixed with a high polymer such as carbowax. The coating solution is coated on the glass and a thermal process, is performed thereon at a high temperature of approximately 450°C to approximately 500°C under an air or oxygen atmosphere. The thermal process is performed at a high temperature of 450°C or higher to remove the high polymer through combustion, improve adhesiveness between the nanoparticles and the transparent conductive substrate, and to induce necking or interconnections between the nanoparticles. Therefore, the nanocrystalline TiO₂ film manufactured at 450°C or higher has good reciprocal interconnections between the nanoparticles, and thus has good photoelectric conversion efficiency.

A transparent conductive plastic substrate needs to be used instead of a transparent conductive glass substrate to manufacture flexible dye-sensitized solar cells. TiO₂ electrodes of plastic based dye-sensitized solar cells need to be formed at a certain temperature or lower so as to protect the plastic substrate. For instance, in the case of a polyethylene terephthalate (PET) substrate, the temperature should be lower than about 150°C. A TiO₂ film formed at a low temperature should have good reciprocal interconnectivity. Therefore, a colloid solution including TiO₂ nanoparticles that can be coated at a high temperature and to which high polymers such as carbowax are added cannot be used with the plastic substrate. A TiO₂ based coating solution that can be coated at a low temperature and contains no high polymer needs to be developed to manufacture a TiO₂ film having good reciprocal interconnectivity at a low temperature.

According to a conventional method of manufacturing such a low temperature coating solution (i.e., a solution that can be coated at a low temperature), TiO₂ nanoparticles are manufactured by dispersing TiO₂ in water or alcohol. It is often difficult to control the viscosity of the coating solution using this manufacturing approach, and as a result, the coating thickness and other coating conditions cannot be easily controlled. When only water or alcohol is used to disperse the TiO₂, the reciprocal interconnectivity between TiO₂ particles at a low temperature may not be easily induced. Accordingly, a TiO₂ paste that can be coated at a low temperature needs to be developed.

### SUMMARY OF THE INVENTION

The present invention provides a composition for a semiconductor electrode of a dye-sensitized solar cell that can be sintered at a low temperature by ensuring reciprocal interconnectivity between nanoparticles.

The present invention also provides a method of manufacturing a composition for a semiconductor electrode of a dye-sensitized solar cell that can be sintered at a low temperature.

The present invention also provides a dye-sensitized solar cell in which damage to a substrate is low and photoelectric conversion efficiency is high by using a composition for a semiconductor electrode that can be sintered at a low temperature.

The present invention also provides a method of manufacturing a dye-sensitized solar cell using a composition for a semiconductor electrode that can be sintered at a low temperature.

According to an aspect of the present invention, there is provided a composition for a semiconductor electrode of a dye-sensitized solar cell, the composition including: a colloid solution containing a nanocrystalline oxide material; and an aqueous base solution.

The nanocrystalline oxide material may be a compound selected from the group consisting of TiO₂, ZnO, and Nb₂O₅. The aqueous base solution may be an aqueous ammonia solution.

According to another aspect of the present invention, there is provided a method of manufacturing a composition for a semiconductor electrode of a dye-sensitized solar cell, the method including: preparing a colloid solution containing a nanocrystalline oxide material by causing a hydrothermal reaction between the nanocrystalline oxide material and a solvent; replacing the solvent for the colloid solution with an alcohol through a substitution reaction; and adding an aqueous base solution to the colloid solution obtained through the substitution reaction. The manufactured paste composition can be used for a semiconductor electrode of a dye-sensitized solar cell.

According to another aspect of the present invention, there is provided a dye-sensitized solar cell including: a semiconductor electrode obtained by coating a paste composition on a conductive substrate, the paste composition comprising a colloid solution containing a nanocrystalline oxide material and an aqueous base solution; an opposite electrode; and an electrolyte solution interposed between the semiconductor electrode and the opposite electrode.

The conductive substrate may be a conductive plastic substrate, a conductive glass substrate, a conductive metal substrate, a semiconductor substrate or a nonconductive substrate. Particularly, the conductive substrate may be a conductive plastic substrate. The semiconductor electrode may further include a layer of dye molecules chemically adsorbed on the paste composition. The layer of dye molecules may include a ruthenium adsorbent. The opposite electrode may be a conductive transparent substrate or a Pt coated transparent substrate. The electrolyte solution may be an iodine based oxidizing and reducing electrolyte.

According to another aspect of the present invention, there is provided a method of manufacturing a dye-sensitized solar cell, the method including: coating a composition of a semiconductor electrode on a first conductivity type substrate, wherein the composition comprises a colloid solution containing a nanocrystalline oxide material, and an aqueous base solution; drying the first conductivity type substrate coated with the composition at room temperature to approximately 200°C; forming a dye molecular layer on the first conductivity type substrate to obtain the semiconductor electrode;coating a conductive material on a second conductivity type substrate to form an opposite electrode; and interposing an electrolyte solution between the semiconductor electrode and the opposite electrode. The dried semiconductor electrode can further be immersed in a TiCl₄ solution and dried again at room temperature to approximately 200 °C. The opposite electrode can be obtained by coating Pt on the other conductive substrate.

Despite not including binders, the paste composition can allow sintering of nanoparticles at a low temperature. The sintering of the nanoparticles can be reinforced by treating the semiconductor electrode coated with the paste composition with the TiCl₄ solution. As a result, damage to the substrate caused by a high temperature process can be prevented. Using the semiconductor electrode coated with the paste composition that can be sintered at a low temperature, dye-sensitized solar cells having excellent photoelectric conversion efficiency can be manufactured.

### BRIEF DESCRIPTION OF THE DRAWINGS

The above and other features and advantages of the present invention will become more apparent by describing in detail exemplary embodiments thereof with reference to the attached drawings in which:
FIG. 1A illustrates a colloid solution including TiO₂ nanoparticles;
FIG. 1B illustrates a paste composition obtained by adding aqueous ammonia to the colloid solution of FIG. 1A;
FIG. 2 is a graph illustrating the viscosity of a composition for a semiconductor electrode according to an embodiment of the present invention versus the weight ratio of an aqueous ammonia solution with respect to TiO₂ nanoparticles;
FIGS. 3A and 3B are diagrams illustrating the viscosity of the composition for a semiconductor electrode according to an embodiment of the present invention before and after an aqueous ammonia solution is added to a colloid solution including TiO₂ nanoparticles, respectively;
FIG. 4 is a simplified diagram illustrating the configuration of a dye-sensitized solar cell according to an embodiment of the present invention;
FIG. 5 is a graph illustrating photocurrent versus voltage in a dye-sensitized solar cell according to an embodiment of the present invention;
FIG. 6 is a graph illustrating the incident photo-to-current conversion efficiency (IPCE) of a dye-sensitized solar cell according to an embodiment of the present invention; and
FIG. 7 is a graph of photocurrent versus voltage in a dye-sensitized solar cell treated with an aqueous TiCl4 solution according to an embodiment of the present invention.

### DETAILED DESCRIPTION OF THE INVENTION.

The present invention will now be described more fully with reference to the accompanying drawings, in which a composition for a semiconductor electrode of a dye-sensitized solar cell and a dye-sensitized solar cell comprising the same according to exemplary embodiments of the invention are shown. Exemplary products and test results will be described. The invention may, however, be embodied in many different forms and should not be construed as being limited to the embodiments set forth herein: rather, these embodiments are provided so that this disclosure will be thorough and complete, and will fully convey the concept of the invention to those skilled in the art.

Although a composition according to embodiments of the present invention may include TiO₂ nanoparticles, zinc oxide (ZnO) or diniobium pentaoxide (Nb₂O₅) as a nanocrystalline oxide material, a semiconductor electrode including TiO₂ is exemplified in the embodiment described herein.

An aqueous colloid solution including TiO₂ nanoparticles is prepared as follows. Titanium isopropoxide, acetic acid, isopropanol, and water are reacted at approximately 230°C for approximately 12 hours using a hydrothermal synthesis method well known in the art. Water is separated from the result using a centrifuge, and alcohol is redistributed thereafter. In order for the composition to be coated at a low temperature, the colloid solution includes approximately 5 to 20 wt% of TiO₂ nanoparticles, more particularly, approximately 10 to 15 wt% of TiO₂ nanoparticles.

An approximately 10 M aqueous ammonia solution is added dropwise to approximately 10 grams of the colloid solution including approximately 12.5 wt% of the TiO₂ nanoparticles while being stirred with a magnetic stirrer. Particularly, the colloid solution and the aqueous ammonia solution are mixed in a weight ratio of approximately 1:0.1 to 10. The molar concentration of the aqueous ammonia solution may range from approximately 1 M to approximately 10 M. As the aqueous ammonia solution is added to the colloid solution, the colloid solution becomes creamy, and the composition is ready to be used for the semiconductor electrode.

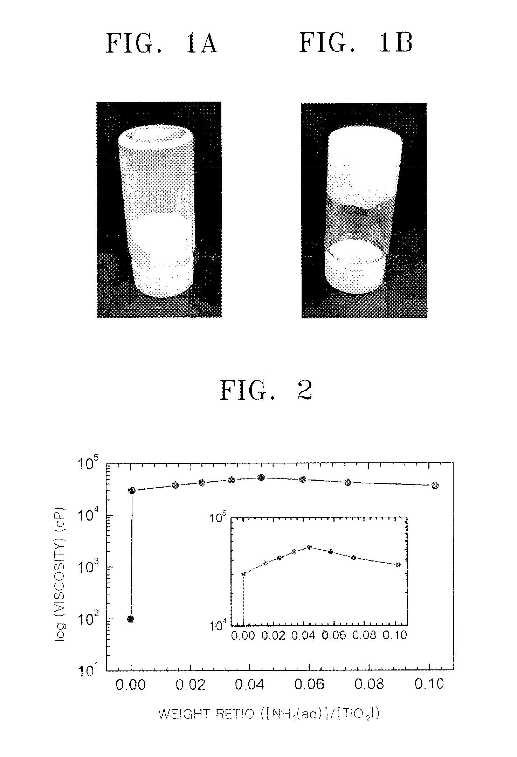

FIG. 1A illustrates a colloid solution including TiO₂ nanoparticles and FIG. 1B illustrates a paste composition obtained by adding aqueous ammonia to the colloid solution of FIC. 1A.

Referring to FIG. 1A, the colloid solution containing nanocrystalline TiO₂ is in a liquid state. On the other hand, when the aqueous ammonia solution is added to the colloid solution, the paste composition, which is highly viscous, is obtained (see FIG. 1B).

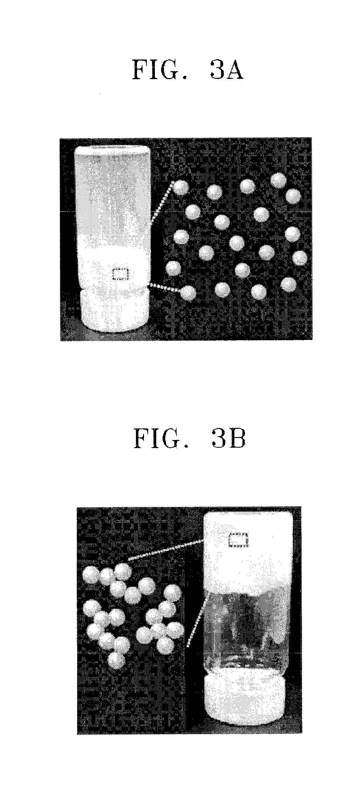

FIG. 2 is a graph of the viscosity of the composition for a semiconductor electrode according to an embodiment of the present invention versus the weight ratio of an aqueous ammonia solution with respect to TiO₂ nanoparticles.

Referring to FIG. 2, a nanocrystalline TiO₂ containing colloid solution with no aqueous ammonia solution has a low viscosity of approximately 100 cP or lower. The composition for the semiconductor electrode obtained by adding approximately 0.5 wt% of the aqueous ammonia solution based on approximately 100w% of TiO₂ to the colloid solution has a high viscosity of approximately 30,000 cP. After the addition of 5 wt% of the aqueous ammonia solution to the colloid solution, the composition has a viscosity of approximately 53,000 cP higher than in the case when no aqueous ammonia solution is added. However, the viscosity of the composition decreases when the amount of the aqueous ammonia solution included is greater than 5 wt% based on 100wt% of the TiO₂ because the amount of distilled water included in the aqueous ammonia increases.

FIGS. 3A and 3B are diagrams illustrating the viscosity of a composition according to an embodiment of the present invention before and after an aqueous ammonia solution is added to a nanocrystalline TiO₂ colloid solution, respectively.

Referring to FIG. 3A, the TiO₂ nanoparticles of the colloid solution having a pH of approximately 1.9 and a viscosity of approximately 100 cP or lower are spaced apart.

Referring to FIG. 3B, when a small amount of the aqueous ammonia solution is added to the colloid solution, a highly viscous paste composition is obtained. The paste composition has a viscosity of approximately 53,000 cP and a pH of approximately 2.2 to 3.6. At this point, some of the TiO₂ nanoparticles are clustered together. In more detail, after the aqueous ammonia solution is added, a surface charge of the TiO₂ nanoparticles, i.e., positive hydrogen ions, decreases due to the neutralization of a base material, and the TiO₂ nanoparticles are flocculated due to an increase in an electrolyte including negative ions obtained from acetic acid and positive ions obtained from ammonium.

A method of manufacturing a dye-sensitized solar cell using the above prepared paste composition according to an exemplary embodiment of the present invention will now be described.

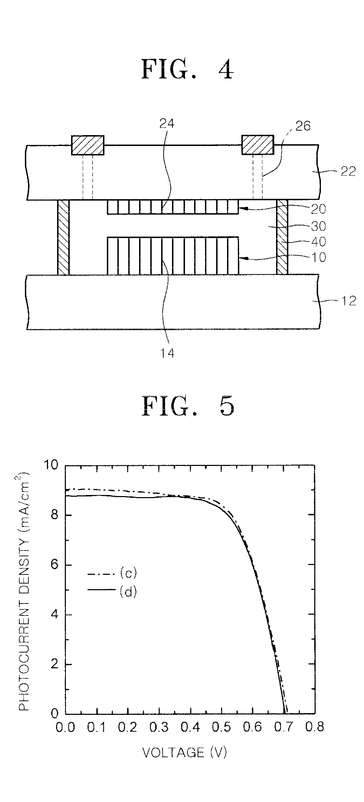

FIG. 4 is a simplified diagram illustrating the configuration of a dye-sensitized solar cell according to an embodiment of the present invention.

Referring to FIG. 4, the dye-sensitized solar cell includes a semiconductor electrode 10, an opposite electrode 20 and an electrolyte solution 30 interposed between the semiconductor electrode and the opposite electrode 20.

The semiconductor electrode 10 is manufactured by coating a paste composition 14 on a transparent conductive substrate 12 using a doctor blade method. Particularly, the paste composition 14 is coated on the transparent conductive substrate 12 such as a transparent conductive plastic substrate or a transparent conductive glass substrate and dried at approximately 150°C under increasing pressure conditions for approximately 10 to 30 minutes. The transparent conductive substrate 12 coated with the dried TiO₂ is immersed in an approximately 0.01 M to 0.6 M TiCl₄ aqueous solution, more preferably, an approximately 0.1 M to 0.3 M TiCl₄ aqueous solution, for approximately 1 to 10 minutes. The transparent conductive substrate 12 is dried in air and then dried again at approximately 150°C under increasing pressure conditions for approximately 10 to 60 minutes.

The opposite electrode 20 is manufactured by coating another transparent conductive substrate 22 with platinum 24. The platinum 24 of the opposite electrode 20 is disposed to face the paste composition 14 of the semiconductor electrode 10. The semiconductor electrode 10 and the opposite electrode 20 are closely adhered with a high polymer layer therebetween. At this time, heat and pressure are applied to the semiconductor and opposite electrodes 10 and 20 to make the high polymer layer adhere strongly to the surfaces of the semiconductor electrode 10 and the opposite electrode 20. The electrolyte solution 30 is filled into the space between the semiconductor electrode 10 and the opposite electrode 20 via micro-openings 26 formed in the opposite electrode 20. The electrolyte solution 30 may include an iodine based oxidizing and reducing electrolyte. After the complete filling of the electrolyte solution 30, thin glass is heated instantaneously to close the micro-openings 26.

FIG. 5 is a graph of photocurrent versus voltage in a dye-sensitized solar cell according to an embodiment of the present invention.

A semiconductor electrode of a dye-sensitized solar cell for a test group was manufactured as follows. A composition for the semiconductor electrode was coated on a transparent conductive substrate to a thickness of approximately 4.2 µm and dried. The transparent conductive substrate was then treated with an aqueous solution of TiCl₄ at a low temperature of approximately 150°C.

A semiconductor electrode of a dye-sensitized solar cell for a comparison group was manufactured as follows. A paste composition including a high polymer binder containing TiO₂ was coated on a transparent conductive substrate to a thickness of approximately 4.7 µm and thermally treated at approximately 500°C for approximately 30 minutes.

Photocurrent and voltage characteristics of semiconductor electrodes of the test group and the comparison group were evaluated. The evaluation results are shown in FIG. 5 and Table 1 below. In FIG. 5, (c) and (d) represent the comparison group and the test group, respectively. Referring to FIG. 5, the test group and the comparison group exhibited similar electric characteristics. Table 1 below shows the details of the electric characteristics. When AM 1.5G-1 solar energy (1,000 Wm⁻²) was applied, the semiconductor electrode of the test group had an energy conversion efficiency of approximately 4.18%, while the semiconductor electrode of the comparison group had an energy conversion efficiency of approximately 4.27%.

**Table 1**

| | Density of Current (mAcm⁻²) | Open Circuit Voltage (V) | Charge Coefficient | Energy Conversion Efficiency (%) |
|---|---|---|---|---|
| Test Group | 8.77 | 0.704 | 0.676 | 4.18 |
| Comparison Group | 9.04 | 0.712 | 0.663 | 4.27 |

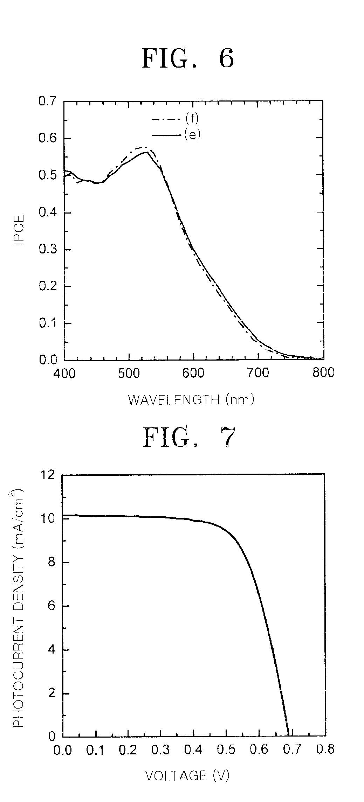

FIG. 6 is a graph illustrating the incident photo-to-current conversion efficiency (IPCE) of a dye-sensitized solar cell according to an embodiment of the present invention.

Particularly, FIG. 6 illustrates the IPCEs of the semiconductor electrodes of the test group and the comparison group. In FIG. 6, (f) and (e) represent the test group and the comparison group, respectively. Referring to FIG. 6, the semiconductor electrode which was manufactured at a low temperature of approximately 150 °C or lower had a similar IPCE to the semiconductor electrode which was manufactured via a high temperature process at approximately 500 °C or higher and had good sintering characteristics between the nanoparticles. Based on this result, the dye-sensitized solar cell according to an embodiment of the present invention has excellent energy conversion efficiency despite excluding binders and being manufactured at a low temperature.

FIG. 7 is a graph of photocurrent versus voltage in a dye-sensitized solar cell treated with an aqueous solution of TiCl₄ according to an embodiment of the present invention.

Particularly, the dye-sensitized solar cell was manufactured as follows. A semiconductor electrode of the dye-sensitized solar cell was formed by coating a paste composition including approximately 20 wt% light scattering TiO₂ particles (anatase type with a crystalline diameter of approximately 400 nm) on a transparent substrate and then treated with an aqueous TiCl₄ solution. The coating was performed at approximately 150°C or lower to a target thickness of approximately 4.5 µm. Referring to FIG. 7 and Table 2 below, the dye-sensitized solar cell had a high energy conversion efficiency of approximately 4.8% under AM 1.5G-1 solar energy (1,000 Wm⁻²). Even though the coating was performed at a low temperature of approximately 150°C or lower, the dye-sensitized solar cell still had the electric characteristic usually obtained through a high temperature process for the following reasons. First, the composition for the semiconductor electrode according to an embodiment of the present invention ensured interconnectivity between the nanoparticles. Second, the chemical post-treatment using the aqueous TiCl₄ solution reinforced the sintering between the nanoparticles. Therefore, according to an embodiment of the present invention, the nanoparticles could be sintered even at a low temperature of approximately 150 °C or lower.

**Table 2**

| | Density of Current (mAcm⁻²) | Open Circuit Voltage (V) | Charge Coefficient | Energy Conversion Efficiency (%) |
|---|---|---|---|---|
| Test Group | 10.16 | 0.689 | 0.682 | 4.8 |

As described above, the composition for the semiconductor electrode according to an embodiment of the present invention includes the TiO₂ nanoparticle containing colloid solution and the aqueous ammonia solution. Despite not including binders, the composition for the semiconductor electrode can be sintered at a low temperature.

According to exemplary embodiments of the present invention, in the manufacturing method of the composition for the semiconductor device, the colloid solution containing TiO₂ nanoparticles is synthesized and then the aqueous ammonia solution was added thereto. Accordingly, the composition for the semiconductor electrode that can be sintered at a low temperature can be manufactured effectively.

According to exemplary embodiments of the present invention, the dye-sensitized solar cell has excellent electrical characteristics based on the aforementioned composition for the semiconductor electrode.

Also, according to exemplary embodiments of the present invention, the semiconductor device can be formed by sintering the nanoparticles even if the paste composition is dried at a low temperature. The electrolyte solution was interposed between the semiconductor electrode and the opposite electrode. After the paste composition is coated, the semiconductor electrode is chemically treated with the TiCl₄ solution. This post-treatment can reinforce the sintering of the nanoparticles. Because the composition for the semiconductor electrode can be coated at a low temperature, damage to the substrate that often results from high temperatures is less likely to occur, and the interconnectivity between the nanoparticles can be improved. As a result, the coating thickness and other coating conditions can be controlled easily.

While the present invention has been particularly shown and described with reference to exemplary embodiments thereof, it will be understood by those of ordinary skill in the art that various changes in form and details may be made therein without departing from the spirit and scope of the present invention as defined by the following claims.

## Claims

1. A composition for a semiconductor electrode of a dye-sensitized solar cell, the composition comprising:
a colloid solution containing a nanocrystalline oxide material; and
an aqueous base solution.

2. The composition of claim 1, wherein the nanocrystalline oxide material is a compound selected from the group consisting of TiO₂, ZnO, and Nb₂O₅.

3. The composition of claim 1 or 2, wherein the aqueous base solution is an aqueous ammonia solution.

4. The composition of claim 1, 2 or 3, wherein the colloid solution and the aqueous base solution are mixed in a weight ratio of approximately 1:0.1 to 1:10.

5. A method of manufacturing a composition for a semiconductor electrode of a dye-sensitized solar cell, the method comprising:
preparing a colloid solution containing a nanocrystalline oxide material by causing a hydrothermal reaction between the nanocrystalline oxide material and a solvent;
replacing the solvent for the colloid solution with an alcohol through a substitution reaction; and
adding an aqueous base solution to the colloid solution obtained through the substitution reaction.

6. The method of claim 5, further comprising stirring the colloid solution while adding the aqueous base solution.

7. The method of claim 5 or 6, wherein the nanocrystalline oxide material includes a compound selected from the group consisting of TiO₂, ZnO, and Nb₂O₅.

8. The method of claim 5, 6 or 7, wherein the aqueous base solution is an aqueous ammonia solution.

9. The method of one of claims 5 to 8, wherein the adding of the aqueous solution to the colloid solution comprises adding the aqueous solution to the colloid solution in a weight ratio of approximately 0.1:1 to 10:1.

10. A dye-sensitized solar cell comprising:
a semiconductor electrode obtained by coating a paste composition on a conductive substrate, the paste composition comprising a colloid solution containing a nanocrystalline oxide material and an aqueous base solution;
an opposite electrode; and
an electrolyte solution interposed between the semiconductor electrode and the opposite electrode.

11. The dye-sensitized solar cell of claim 10, wherein the conductive substrate is a conductive plastic substrate.

12. The dye-sensitized solar cell of claim 10 or 11, wherein the nanocrystalline oxide material is a compound selected from the group consisting of TiO₂, ZnO, and Nb₂O₅.

13. The dye-sensitized solar cell of claim 10, 11 or 12, wherein the aqueous base solution is an aqueous ammonia solution.

14. The dye-sensitized solar cell of one of claims 10 to 13, wherein the paste composition comprises the colloid solution and the aqueous base solution in a weight ratio of approximately 1:0.1 to 1:10.

15. A method of manufacturing a dye-sensitized solar cell, the method comprising:
coating a composition of a semiconductor electrode on a first
conductivity type substrate, wherein the composition comprises a
colloid solution containing a nanocrystalline oxide material, and an
aqueous base solution;
drying the first conductivity type substrate coated with the composition at room temperature to approximately 200°C;
forming a dye molecular layer on the first conductivity type substrate to obtain the semiconductor electrode,
coating a conductive material on a second conductivity type substrate to form an opposite electrode; and
interposing an electrolyte solution between the semiconductor electrode and the opposite electrode.

16. The method of claim 15, further comprising immersing the first conductivity type substrate in a TiCl₄ solution and then drying the first conductivity type substrate at room temperature to approximately 200°C.

17. The method of claim 15 or 16, wherein the coating the composition for the semiconductor electrode on the first conductivity type substrate is performed using a doctor blade method.

18. The method of claim 15, 16 or 17, wherein the nanocrystalline oxide material is a compound selected from the group consisting of TiO₂, ZnO, and Nb₂O₅.

19. The method of one of claims 15 to 18, wherein the aqueous base solution is an aqueous ammonia solution.

20. The method of one of claims 15 to 19, wherein the paste composition comprises the colloid solution and the aqueous base solution in a weight ratio of approximately 1:0.1 to 1:10.
